# EUROPEAN PATENT SPECIFICATION

(11) **EP 0 635 074 B1**
(45) Date of publication and mention of the grant of the patent: **04.09.1996**
(21) Application number: 93903918.6
(22) Date of filing: 05.02.1993
(51) Int. Cl.: C30B 11/00, C03B 37/095

(54) **Spinner in the form of a single crystal metal component for producing fiber products by centrifuging molten mineral materials and process for its manufacture**
Zerfaserungsgrad in Form eines monokristallinen Metallbauteils für die Herstellung von Fasermaterialien mittels Zentrifugieren von erschmolzenen mineralischen Werkstoffen,sowie Verfahren zu seiner Herstellung
DISPOSITIF DE PRODUCTION D'UNE MATIERE FIBREUSE PAR CENTRIFUGATION D'UNE MATIERE MINERALE FONDUE, SE PRESENTANT SOUS FORME D'UN COMPOSANT MONOCRYSTALLIN METALLIQUE, ET PROCEDE DE FABRICATION

(43) Date of publication of application: 25.01.1995
(73) Proprietor: ISOVER SAINT-GOBAIN, F-92400 Courbevoie (FR)
(72) Inventor: BERNARD, Jean Luc, Giencourt, F-60600 Clermont (FR)
(74) Representative: KUHNEN, WACKER & PARTNER
(86) International application number: EP9300281
(87) International publication number: WO9418363

(56) References cited:
- EP-A- 0 149 942
- EP-A- 0 187 444
- EP-A- 0 358 185
- FR-A- 2 536 385
- FR-A- 2 599 757
- US-A- 4 459 160

## Description

### TECHNICAL FIELD

The invention relates to a metal spinner component for producing wool or other fibre products made of mineral material, to a specific component in form of a spinner for the production of mineral wool material for insulating purposes by centrifugation of molten mineral material through a multitude of orifices of small diameter in a circumferential wall of said spinner, and to a method of producing such a component, specifically such a spinner.

### BACKGROUND ART

Metal components of this kind are subject to corrosive attack by the mineral melt like molten glass, basalt or the like. The corrosion occurs in components like bushings or the like without substantial mechanical strain, which are subject to temperatures of 1300°C and more, and in components like spinners under mechanical strain. In either case, elements or compounds of the melt react with constituents of the metal component with the consequence of a depletion thereof of certain constituents which eventually leads to failure or strength decrease, or need of replacement, of the component. In case ofa component made from metal forming a passivation layer against corrosion or oxidation, the mineral melt will tend to dissolve such passivation layer with the consequence that the layer is constantly rebuilt through diffusion of the dissolved constituents from the component, a process which eventually also leads to a decrease of the concentration of the dissolved constituent in the metal component. Thus, where a chromium oxide film is formed as passivation layer like in case of a carbide-hardened metal superalloy on the basis of nickel or cobalt, the attack of the molten mineral material will deplete chromium, and where an aluminium oxide film is formed as passivation layer as in a gamma-prime superalloy, aluminium will be depleted with the consequence that eventually there will not be sufficient aluminium left in the alloy to form the intermetallic Ni₃Al phase.

This situation is further aggravated if the component is also subject to substantial mechanical strain, as in case of a so-called spinner.

Such spinners for the so-called internal centrifugation of molten mineral material so as to be attenuated into mineral fibers to form mineral wool for thermal and/or acoustical insulation purposes are subject to a variety of critical strains: They have to operate at high temperatures often well in excess of 1000°C, and under high mechanical strain due to the mechanical centrifugal forces created by the high velocity of rotation. Simultaneously, they are subject to corroding and oxidizing attacks by the molten mineral material and by hot gas streams used to attenuate the melt filaments into fibers. For these reasons, it is difficult to obtain a useful service life of such spinners which satisfies economical requirements as regards minimizing interruptions of the mineral wool production for spinner exchange, and minimizing unit costs as such of the spinners consumed.

In an effort to prolong the service life of spinners used in the production of glass fibers, US-A-4,402,767 suggests to use so-called oxide dispersion strengthened (ODS) alloys for spinners of this kind. In the production of these ODS materials, a fine powder of oxide particles is dispersed within a metallic matrix, also in powder form, for subsequent consolidation and mechanical alloying.

The ring rolling technology used thereby is limited to the formation of cylindrical parts with only small radial flanges so that more complicated shapes must be formed by a composite technique disclosed in US-A-5,118,332.

This ring rolling production technique starting from fine powders is very delicate to practice and requires a high degree of expertise in technical fields very different from metal casting as conventionally used for the production of such components including spinners. Moreover, while the corrosion resistance is satifactory also with ODS material, the extreme production effort is prohibitive for parts not subject to mechnical strain and thus justifying such efforts. Furthermore, it is doubtful whether a spinner made from ODS alloy material will exhibit an economical service life time at very high operation temperatures in excess of 1200°C or even 1300°C. At such high temperatures micro-fissures tend to occur because of different thermal expansion of individual phases and the limited ductility of the ODS material.

Such high operation temperatures, however, are a requirement for such spinners if used for producing rock wool as taught in PCT/EP92/01754 of the present applicant. Moreover, it is of great practical concern that the molten rock (e.g. basalt) material is much more aggressive than molten glass as regards corrosion so that under these conditions it is still much more difficult to obtain a satisfactory service life time of the spinner.

### DISCLOSURE OF THE INVENTION

It is therefore an object of the present invention to provide a metal component which in use is in contact with the molten mineral material, and which has an improved corrosion resistance against the influence of the mineral melt. It is a further object of the present invention to provide a metal component which in use is in contact with the molten mineral material, and which yields a longer service life time before shut-down of the production operation for repair or replacement is necessary.

It is a further object of the present invention to provide metal component in form of a spinner for the purpose as stated which yields an acceptable service life time also under high operating temperatures.

According to the invention, these and other objects of the invention are attained by use of the alloy in the form of a single crystal.

Such single crystal alloys have been developed in the sixties in the jet propulsion industry for producing turbine blades without grain boundaries as a potential source of creep or crack phenomena. The single crystal concept avoiding any grain boundaries makes use of the gamma-prime or equivalent crystallites finely dispersed in a gamma or similar matrix and impeding dislocations in the crystal structure from progressing through the material under shear forces.

With metal components of the present invention, it has been found that the corrosion resistance against corrosive attack by the melt is greatly increased as compared to a poly-crystal component of the same composition. It appears that the absence of grain boundaries avoids any inhomogeneities caused thereby, and also avoids corrosive and/or oxidizing effects of which grain boundaries are a potential source. Thus, the absence of grain boundaries favourably increases the chemical resistance against corrosive and/or oxidizing attacks, which, especially at the more elevated operating temperatures and with more aggressive materials, as preferred in the invention, are a matter of major concern.

Moreover, while the geometry of a component like a spinner for the stated purpose is drastically different from the slant geometry of a turbine blade, the absence of grain boundaries and thus related dangers of increased creep or crack phenomena may, according to the invention, also in case of such component be utilized to increase the mechanical strength properties.

Moreover, it has been found that the high temperature ductility of single crystal superalloys generally is superior to the ductility of conventional alloys used for such spinners as well as of ODS alloys. Ductility is of decisive importance under high temperature operation with locally different thermal expansion due to different temperature levels or material characteristics because it allows to take up the inevitable stresses brought about by expansion differences. The higher the temperature level of operation, the higher generally are the temperature and the expansion differences between various points of the component or spinner under more or less direct influence of heating means and/or the melt, and the lower is the strength reserve of the material under a given strain. Therefore, a high ductility avoids any substantial build-up of additional local stresses, on top of the high mechanical strain due e.g. to the mechanical centrifugal forces, that might bring about premature failure.

Single crystal superalloys have not been used hitherto at temperatures beyond 1100°C, nor in conjunction with aggressive molten mineral material. Surprisingly, components like spinners made in accordance with the present invention have been found best suited to operate satisfactorily under such different and severe conditions, and to obtain an economically acceptable service life time.

### SINGLE CRYSTAL FORMATION

If the growth direction of the single crystal is at least substantially parallel to an axis of symmetry of the component like the central axis of symmetry of the spinner, there will in many cases be produced a maximum amount of symmetry in the crystal structure, thus minimizing unsymmetrical distribution of characteristics like the creep behaviour. Moreover, this facilitates homogeneous growth of the crystal.

If the growth direction of the single crystal coincides with its [001] orientation, natural dendritic growth may be utilized. Growth in this direction regularly occurs upon solidification in the absence of any constraints. However, if a different growth direction is desired e.g. the [111] orientation for a most isotropic distribution of characteristics like modulus of elasticity, this may be done with the aid of a nucleus in the form of a cutting from a crystal oriented in such a way that the gradient of temperature enforcing solidification is in the desired direction of e.g. the [111] orientation. Also, the direction of the gradient of temperature could be selected in such a way that natural dendritic growth in [001] orientation leads to a direction of symmetry or other preferred direction of the workpiece in a different direction than the [001] orientation, if the workpiece in a given case allows so.

### USE OF SUPERALLOYS

If the component is subject to mechanical strain at high temperatures under such corrosive conditions, the single crystal alloy should be selected to be a superalloy prefereably on the basis of nickel or cobalt. The term superalloy as used herein shall define a metal alloy containing finely dispersed precipitates in a surrounding matrix, the precipitates impeding movement of dislocations of the crystal lattice through the matrix up to high temperatures and thus minimizing creep. Such superalloys which are particularly suited for spinners, may be preferably carbide hardened or gamma-prime hardened.

If a carbide hardened superalloy is selected, this may be based on either nickel or cobalt. Preferred nickel based alloys of this type are within the following ranges of components (in weight per cent):
- Cr: 20 - 35 %
- Co: 0 - 20 %
- Mo: traces at most
- W: 0 - 12 %
- Ti: traces at most
- Ta: 0 - 5 %
- Re, Y, La and other rare earths: < 2 %
- C: 0.1 - 3 %
- Si: 0 - 3 %
- Mn: 0 - 2 %
- Fe: 0 - 10 %
- Ni: remainder

Preferred cobalt based alloys of this type are within the following ranges of components (in weight per cent):
- Cr: 20 - 40 %
- Ni: 0 - 15 %
- Mo: traces at most
- W: 0 - 12 %
- Ti: traces at most
- Ta: 0 - 5 %
- Re, Y, La and other rear earths: < 2 %
- C: 0.1 - 1 %
- Fe: 0 - 10 %
- Co: remainder

It should be noted that the metaloid elements N, O, S, B and the metal Zr are avoided. These are conventionally utilized in small quantities to strengthen the grain borders of polycrystals, but have the property to lower T_{SOLIDUS}. As will be seen in more detail hereafter, such lowerring of T_{SOLIDUS} of the alloy lowers the distance available between T_{SOLIDUS} and T_{SOLVUS} for the eutectic mixture of the gamma matrix and particular precipitation phases. This makes it more difficult in a subsequent heat treatment to hold the workpiece at an intermediate temperature between these two temperatures.

Using the alloys in an extremely pure form also limits the risks of segregations due to the presence of low melting phases, and of the possibilities to form undesired crystalisation nulclei and the growth of secondary grains.

Also Mo and Ti are avoided as much as reasonable as they tend to adversely affect the corrosion behaviour. The corrosion behaviour of this type of alloy is particularly good in view of a passivation layer formed of Cr₂O₃ and the extremely high chromium content. Even a difusion of chromium to the surface of the work piece for reconstitution of any removed passivation layer does not adversly affect the properties of the workpiece to any remarkable extend in view of the high chromium content. Moreover, the Cr₂O₃ layer is relatively stable against molten material like glass or basalt.

Preferred single crystal superalloys with gamma-prime hardening are nickle-based and within the following ranges of components (in weight per cent):
- Cr: 5 - 20 %, preferably up to 10 %
- Co: 4.5 - 15 %
- Mo: 0 - 20 %
- W: 0 - 10 %
- Al: 3 - 6 %
- Ti: 0 - 3.5 %
- Ta: 0 - 15 %
- Re: 0 - 3 %
- V: 0 - 1 %
- Hf: 0 - 1.4 %
- C: 0 - 0.07 %
- Ni: remainder

Even more satisfactory results have been found within the following ranges of components (in weight per cent):
- Cr: 6 - 10 %
- Co: 4.5 - 7 %
- Mo: 1 - 3 %
- W: 4 - 10 %
- Al: 5 - 6 %
- Ti: 1 - 3 %
- Ta: 2 - 10 %
- Re: 0 - 2 %
- Ni: remainder

Again, metaloid elements like N, O, B, S, and in this case also C, and the metal Zr are avoided for the reasons as stated above with respect to the carbide hardened alloys.

The elements Al, Ti and Ta favour the formation and the stability of the intermetallic phase Ni₃Al, whereas Cr and Mo accumulate with preference in the gamma phase, and W is relatively indifferent.

The corrosion resistance to some extent depends on the content of chromium, the oxidation resistance on the content of aluminium forming the Al₂O₃ layer. A compromise for the content of chromium in the order of 7 - 8 % serves to simultaneously obtain hardening and corrosion resistance. The aderance of the aluminium oxide layer is not always sufficient and can be supported by a surface coating of intermetallic compound with aluminium like aluminide.

With higher contents of Ta, Ti and W and lower contents of chromium it is possible to increase T_{SOLIDUS} and T_{SOLVUS} for the eutectic mixture of the gamma and gamma-prime phases.

While these gamma-prime hardened superalloys cannot form a Cr₂O₃ passivation layer, their resistance against corrosion nevertheless is high in view of the presence of an extremely stable intermetallic Ni₃Al phase and, of course, the absence of any grain boundaries where aggressive material could penetrate into the workpiece. As the aluminium is very firmly bound in the stable gamma-prime phase, it cannot easily diffuse to the workpiece surface and deplete. Thus, the high degree of atomic order in the single crystal avoids such depletion and thus substantially increases corrosion resistance. Therefore, it is preferred to have a cubic face centered structure, which is reinforced by an intermetallic phase (Ni₃Al) as coherent as possible in crystallographic sense with the base structure (gamma-prime precipitate in gamma matrix).

Re, Y, La and other rare earths contained in both the carbide hardened and the gamma-prime hardened superalloys in small quantities serve to increase the oxidation especially spalling effect resistance without impairing the refractory properties.

Out of the superalloys tested, the compositions listed in Table 1 were found suitable for the invention:

Out of these, superalloys Nos. 1 thru 3 and 13 are most preferred, and, among these, superalloy No. 1 is the most preferred one at present.

It has been found that the oxidation behaviour of the single crystal superalloy against the hot attenuating gases may

**Table 1**

| Superalloy | Element (wt.%) | | | | | | | | | | | | | | |
|---|---|---|---|---|---|---|---|---|---|---|---|---|---|---|---|
| # | Ni | Cr | Co | Mo | W | Al | Ti | Ta | Re | V | Hf | C | Fe | Si | Mn |
| 1 | Bal. | 8 | 5 | 2 | 8 | 5 | 1.5 | 6 | - | - | - | - | - | - | - |
| 2 | Bal. | 8 | 5.5 | 2.25 | 5 | 6 | 2 | 3.5 | - | - | - | - | - | - | - |
| 3 | Bal. | 7.8 | 6.5 | 2 | 5.7 | 5.2 | 1.1 | 7.9 | - | - | - | - | - | - | - |
| 4 | Bal. | 10 | 15 | 3 | - | 5.5 | 4 | - | - | 1 | - | 0.02 | | - | - |
| 5 | Bal. | 8 | 5 | 2 | 8 | 5 | 1.5 | 6 | - | - | - | - | - | - | - |
| 6 | Bal. | 10 | 5 | - | 4 | 5 | 1.5 | 12 | - | - | - | - | - | - | - |
| 7 | Bal. | 8 | 4.6 | 0.6 | 7.9 | 5.6 | 0.9 | 5.8 | - | - | - | - | - | - | - |
| 8 | Bal. | 6.5 | 10 | 0.6 | 6 | 5.6 | 1 | 6 | 3 | - | 0.1 | - | - | - | - |
| 9 | Bal. | 16 | - | 3 | - | 3.5 | 3.5 | 3.5 | - | - | - | - | - | - | - |
| 10 | Bal. | 15 | 5 | 2 | 2 | 5 | 2 | 5 | - | - | - | 0.02 | | - | - |
| 11 | Bal. | 5 | 10 | 20.6 | 6 | 5.6 | - | 9 | 3 | - | 0.1 | - | - | - | - |
| 12 | Bal. | 8 | 9 | 0.5 | 10 | 5.6 | 0.7 | 3.2 | - | - | 1.4 | 0.07 | | - | - |
| 13 | Bal. | 29 | - | - | 7.4 | - | - | - | - | - | - | 0.7 | 7.5 | 1.2 | 0.9 |

present a problem especially in case of carbide hardened alloys forming a passivation layer from Cr₂O₃, the chromium of which may become volatile under the influence of hot gases. Therefore, it is preferred to have at least part of the component or spinner surfaces protected against corrosive and/or oxidizing attacks by a coating of the type as it is also used for turbine blades in the jet propulsion industry for such protective purposes. Thus, for suitable compositions and methods of deposition as regards the coating, reference may be had to the literature dealing with protective turbine blade coatings. Preferably this coating is provided at the outer spinner surfaces exposed to the hot gases of an outer burner producing an attenuating gas stream.

### METHOD OF PRODUCING THE COMPONENT

In the production of a component according to the present invention, a melt of the superalloy material is introduced into a casting receptacle consisting of a lower crystal forming chamber having a cooled surface and an upper workpiece-forming chamber capable of being heated, with a single crystal selecting constriction therebetween, and the single crystal growing from the constriction into the upper chamber to take up the form of the workpiece is gradually solidified by changing the relative position between the casting receptacle and the heating means such that there is established a temperature gradient from the constriction to the opposite end of the workpiece to be formed.

While changing the relative positions by drawing out the casting receptacle from inside a hood-shaped induction heating means is the most practical and reliable method of establishing the temperature gradient such that the region of the constriction starts being cooled down while the opposite end of the workpiece still is fully heated, of course equivalent means to achieve this end could be utilized if need be. The casting process and the cooling down are carried out under vacuum of 10⁻³ bar or less to avoid any ingress of impurities from the ambient atmosphere. The temperature of casting is some 200°C above T_{SOLIDUS} of the alloy and thus typically in excess of 1500°C.

While test pieces on laboratory scale where successfully solidified with a temperature gradient of up to 230°C/cm, use of the process in an industrial scale seems to favour a temperature gradient below 70°C/cm, preferably below 50°C/cm. The temperature gradient has been found to be optimum, on the other hand, if in excess of 30°C/cm, prefereably of 40°C/cm.

Correspondingly, the maximum velocity of moving the casting receptacle in relation the heating means is preferred between 15 and 35 cm/h. Where we have a cylindrical workpiece or part of a workpiece, this can be a constant velocity whereas in case of parts having a radial component this velocity should be reduced according to the degree of inclination of the radially extending portion.

In a preferred form of the invention, the walls of the casting receptacle are of ceramic material obtained from forming a ceramic material layer on the surface of a model made from material removable by heat like wax or organic plastic material, such model taking the form of the workpiece plus spaces to be filled by molten alloy material, with the material of the model being removed from the ceramic mould before pouring in the molten alloy material. In this way, also complicated forms can be cast with high accuracy and thus a minimum of subsequent machining necessary.

After casting, the workpiece may contain segregations, pores and inner stresses.

Inner stresses may be a source of local parasite crystallisation adversely affecting the unitary character of the single crystal. Therefore, the mould release should be effected without using shocks or vibrations which might initiate uncontrolled crystallisation. Instead, chemical dissolution of the ceramic mould material e.g. by an acid is preferred to mechanical mould release.

Also, subsequent homogenisation and annealing of the workpiece to remove local stresses, pores and segregations is preferred. If such subsequent heat treatment includes heating the workpiece to a temperature T₁ between the solution temperature T_{SOLVUS} for the eutectic mixture of the gamma and gamma-prime phases on the one hand and the T_{SOLIDUS} of the alloy on the other hand for more than one hour, preferably three hours, also segregations and all of the particulate precipitation phase will be dissolved in a first step to prepare optimization of the particulate precipitation distribution for maximum mechanical strength of the superalloy. The solutioning and homogenisation so achieved is maintained by quenching the workpiece to ambient temperature.

Temperature T₁ is preferably selected between 1150°C and 1350°C and in case of alloy No. 1 in table 1, the temperature T₁ is preferably selected to be around 1300°C.

In addition to this solutioning and homogenisation, the heat treatment includes heating the workpiece up to a temperature T₂ of between 150°C and 200°C below the solution temperature T_{SOLVUS} for the eutectic mixture of the gamma and gamma-prime phases for a duration of more than one hour, preferably four hours. This heat treatment ensures precipitation of the particulate, e.g. gamma-prime phase in a finely dispersed mode which is stabilized by quenching the workpiece to ambient temperature. Subsequently, the workpiece is heated up to between 400 and 500°C below the solution temperature T_{SOLVUS} for the eutectic mixture of the gamma and gamma-prime phases for a duration for more than 10 hours, preferably 24 hours. This will lead to a growth of the finely and homogenously dispersed precipitates like gamma-prime so that in many cases more than 50 % of the alloy is in the particulate precipitation phase within the gamma matrix.

In case of alloy No. 1, the temperature T₁ is preferred to be 1100°C, and temperature T₂ 850°C. This leads to a content of gamma-prime phase of up to 70 %, and a size of the gamma-prime precipitation particles of 300 to 500 nm, preferably around 400 nm.

### BRIEF DESCRIPTION OF THE DRAWINGS

- Fig. 1: is a perspective view of a component of the invention in the form of a spinner.
- Fig. 2: is a schematic view of a production device for the spinner of Fig. 1.
- Fig. 3: is a graph showing the creep resistances of various materials of the prior art and of the invention.
- Fig. 4-7: are photographs showing the microstructure produced by the process of the invention in its individual stages.

### BEST MODE OF CARRYING OUT THE INVENTION

### THE COMPONENT

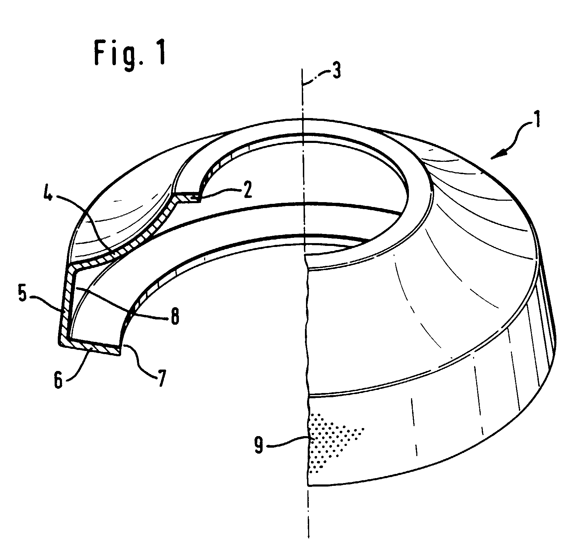

In Fig. 1, a component of the invention in the form of a spinner 1 is shown. The spinner 1 has an upper collar 2 for its fixation at the hub of a rotating shaft for rotating the spinner 1 around its axis of symmetry 3. The spinner 1 also comprises a curved upper flange 4, a foraminous peripheral wall 5 and a lower flange 6 projecting radially inwardly from the lower end of peripheral wall 5 and defining a large central opening 7.

As is well known in the internal centrifugation technique using such kind of spinners, molten mineral material is being introduced into the space within the foraminous peripheral wall 5 of spinner 1 quickly rotating around axis 3 so that centrifugal forces press the molten mineral material against the inner surface 8 of wall 5 and through the multitude of orifices 9 of the peripheral wall 5 to exit therefrom as radially outwardly directed fine melt filaments. The melt filaments exiting from the orifices 9 then enter into a downwardly directed stream of hot attenuating gases emanating from an outer annular burner to form fibers.

For further details as regards construction and use of such a spinner reference is had to EP-A-0 091 866 the contents of which is here incorporated by reference in full.

The internal centrifugation technology as such is well known per se, and therefore not described in detail herein.

The spinner 1 may be of the form indicated, but it may alternatively also have a different form, like e.g. a form closing central opening 7 by a bottom wall. In such a case it may be sufficient to form the walls of the spinner 1 shown in Fig. 1 as a unitary part, and to add a bottom wall so as to form the spinner from composite parts fixed together. As such a part like a bottom wall radially inside of the lower flange 6 is not subject to the maximum centrifugal forces acting at the level of the peripheral wall 5, and may not be in contact with the molten mineral material, it may well consist of a different material than the part of the spinner shown in Fig. 1. It is well understood that the invention comprises both cases of a unitary spinner and of a unitary part of the spinner to be complemented by additional parts.

### THE METHOD OF PRODUCING THE COMPONENT

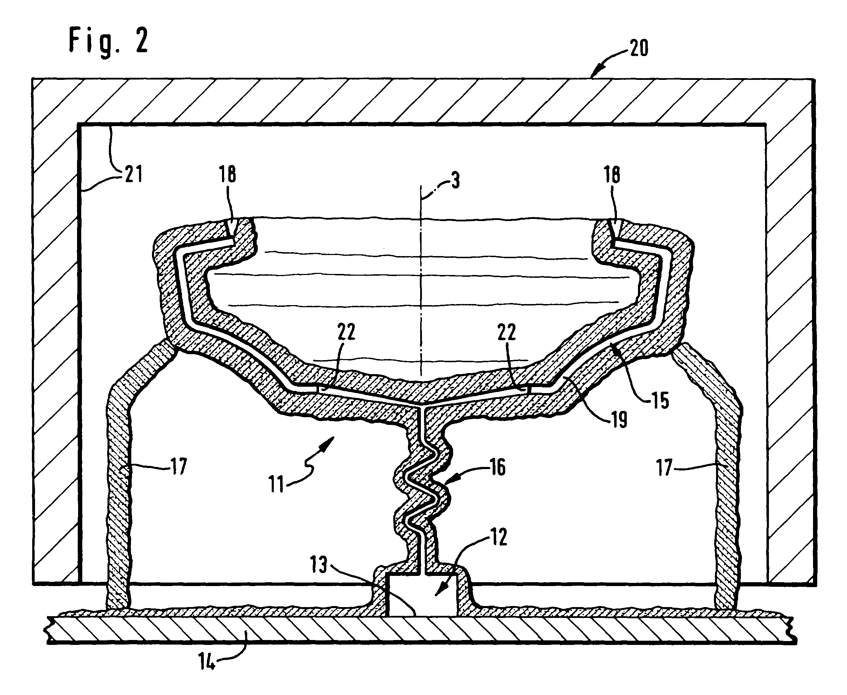

For the production of the spinner 1, a device as schematically shown in Fig. 2 may be used according to the present invention. As is shown in Fig. 2, a casting receptacle 11 has a lower nucleation chamber 12 having a cooled surface 13 formed by a plate 14 cooled by a water jacket (not shown), and comprises an upper workpiece forming chamber 15 with a single crystal selecting constriction 16, or starter, therebetween. The receptacle 11 is in the form of a ceramic mould, the walls of which have a thickness of about 1 cm and have been produced with the aid of a wax model taking the shape of the workpiece and the other spaces to be filled by melt, this wax model then being clad with ceramic material, e.g. by an immersion and deposition process. After drying thereof, the wax may be removed from the interior of the ceramic mould by heating the assembly up to a temperature above the fusion temperature of the wax so that this may flow out. Subsequently, the ceramic material is sintered at temperatures above 1000°C.

As the casting receptacle 11 is in the general shape of an inverted cone, supports 17 also made of ceramic material are provided for stabilisation. Furthermore, in the area of the constriction 16, or starter, the wax may be replaced by some organic plastic material of greater strength like solid polystyrene to avoid damages at this delicate area during manufacture of the ceramic mould. Of course, also the organic plastic material may be removed by application of heat.

The mould or receptacle 11 also comprises a plurality of risers and feeders 18 as needed to allow inflow of the metal melt into the cavity 19 of the mould or receptacle 11, and the proper escape of air or gases from cavity 19.

Around the receptacle 11, there is a heating means 20 in the form of an induction heating hood having an inner surface 21.

In operation, the metal melt is introduced into the cavity 19 of receptacle 11 filling all of the lower chamber 12 and the upper chamber 15 up to risers 18 before any solidification occurs. To avoid premature solidification, heating means 20 keeps the temperature of receptacle 11 well above the solidification temperature.

The cooled surface 13 of cooled plate 14 initiates solidification in the lower crystal forming chamber 12 so that a plurality of crystals may develop therein and grow upwardly towards constriction 16. However, constriction 16 has a small cross-sectional area, and is so shaped, e.g. in the form of a helical path, that only one of the crystals may enter the constriction 16 and will appear at its upper end, i.e. at the bottom of the upper workpiece forming chamber 15. Thus, as is generally known in the single crystal pulling technology, only one single crystal grows into the workpiece forming chamber 15 if, through gradual movement of the receptacle 11 out of the hood 20 with small velocity and a suitable thermal gradient, the formation of other crystals is suppressed.

If direction of movement and thus the temperature gradient are along the axis of symmetry 3 of the spinner 1, or the workpiece, the growth of the single crystal, or the pulling direction, will be in the direction of the axis of symmetry 3 thus contributing to an isotropic distribution of characteristics around the axis of symmetry and thus, in case of spinner 1, around the axis of rotation. This contributes to the perfection of the rotation symmetry of the spinner.

If no further measures are taken, the single crystal will grow in its natural dendritic [001] direction. This is the less complicated way and leads to a good isotropic distribution of the creep behaviour. However, it may also be considered advantageous to have the [111] orientation in the direction of the axis of symmetry 3 so as to optimize the isotropic distribution of other characteristics like the modulus of elasticity. To this end, a nucleus has to be used within the crystal forming chamber 12, this nucleus being cut from a solid single crystal in such a way that its [111] orientation is in the direction of the axis of symmetry 3 if the nucleation piece is placed on surface 13. If the component or workpiece allows so, such result could also be achieved without nucleus by changing the pulling direction of the single crystal to such an inclinition to the axis of symmetry that the natural dendritic [001] orientation in the pulling direction of the single crystal leads to the [111] orientation to coincide with the axis of symmetry 3.

The nucleation piece would typically be a cylindrical slice from a single crystal placed on surface 13. However, there also is the alternative available to have the nucleation piece take the form of the connecting space between the upper end of constriction 16 and the lower and/or inner rim 22 of the workpiece. In case of the spinner shown in Fig. 2, this is conical shape consisting of regularly outwardly extending spokes connecting the upper end of constriction 16 with evenly distributed locations on lower and inner rim 22. Such technique would make the casting process two-stage: In a first stage a starting piece filling the crystal forming chamber 12, the constriction 16 and the space up to the lower inner rim 22 will be manufactured as described above, avoiding the complications originating from all of the workpiece above such space. From this starting piece the portion above the constriction 16 in the form of a single crystal would be cut, and in a second stage, with the upper end of constriction 16 being the lower most point of the mould now used, utilized as nucleation piece for casting the workpiece beginning at rim 22 connected to the nucleation piece.

The arrangement of the workpiece forming chamber 15 and the orientation of the work piece therein should take account of the fact that a cross-section increasing in growth direction favours proper growth of the single crystal. For this reason, spinner 1 is cast in an inverted position as shown in Fig. 2. This inverted position of spinner 1 reorientates protruding ring 10 to a downward direction, i.e. approx. a counterdirection to the general pulling direction of the single crystal. If such conditions turn out to be a problem for proper single crystal growth, the workpiece may, as shown in Fig. 2, have a form enveloping protrusions like the protruding ring 10 thus avoiding any difficulty originating therefrom, and favourably increasing the cross-section of the workpiece. However, this necessitates subsequent machining which otherwise might not be necessary in view of the excellent surface finish achieved by the ceramic mould.

As the workpiece as solidified by drawing the casting receptacle 11 out of heating means 20 has inner stresses, there is a danger of local parasite crystallisation if additional shocks or vibrations are applied to the workpiece. Therefore, for mould release mechanical strains on the work piece should be avoided, and chemical dissolution of the ceramic mould material by a suitable agent like an acid is preferred.

The inner stresses, pores and segregations are removed by a subsequent heat treatment as described in more detail at other places of this specification. This heat treatment also serves for achieving a homogeneously dispersed precipitate of a suitable amount and size in the matrix of the superalloy if a superalloy is used for the component.

### EXAMPLE OF THE INVENTION

A melt having the following components in weight per cent was introduced into the cavity 19 of receptacle 11 at a temperature of 1520°C:
- Cr: 8 %
- Co: 5 %
- Mo: 2 %
- W: 8 %
- Al: 5 %
- Ti: 1.5 %
- Ta: 6 %
- Ni: remainder.

Heating means 20 were operated to prevent any premature solidification of the melt, and plate 14 was cooled to initiate solidification at surface 13. Hood 20 and receptacle 11 were moved apart with a maximum speed of 25 cm/h so as to finally pull the single crystal emanating from constriction 16 up to risers 18. In this way, a thermal gradient of approx. 40°C/cm was created in the workpiece.

The moving speed of the casting receptacle 11 may vary and be lower at times to take account of portions of the workpiece with radial components like flanges 4 and 6 so as to limit the thermal gradient in these regions. All in all, the pulling time for the workpiece may be in the order of one hour.

After having allowed the workpiece to cool down to ambient temperature, the lower flange 6 of the spinner 1 is cut free from the material connecting it with constriction 16.

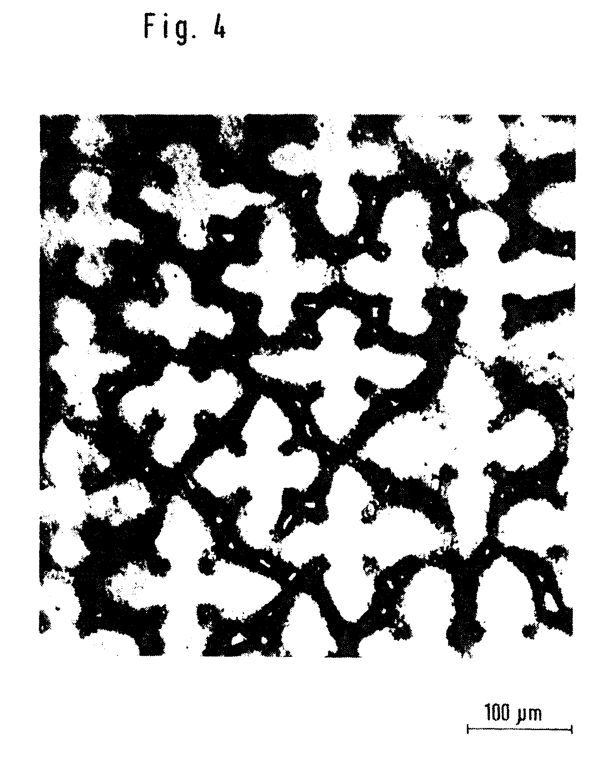

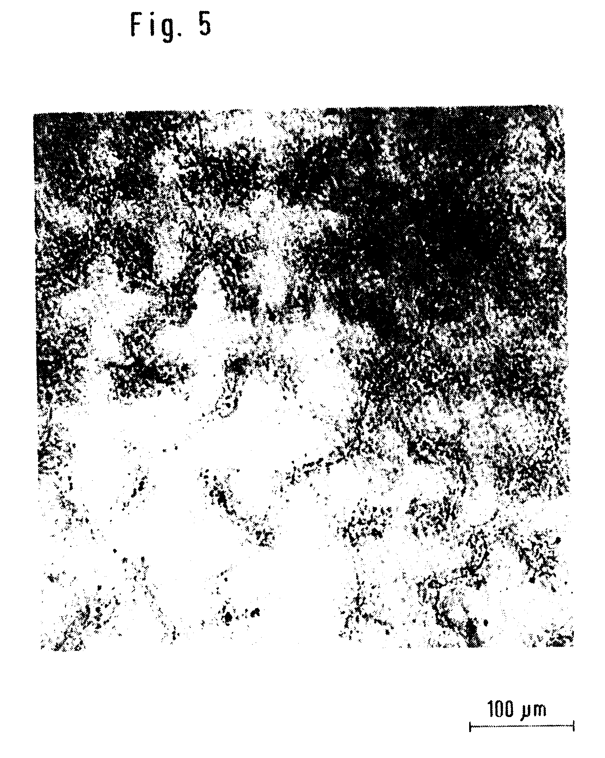

The as-cast single crystal produced by the process so far described is shown in Fig. 4 in a magnification of about 250:1 as can be verified by the scale represented in Fig. 4. Fig. 4 shows the dendritic structure and an interspersion of white areas which represent eutectic spots of the gamma and gamma-prime phases segregated between the dendritic segregations when cooling down. By a first solutioning heat treatment bringing the workpiece up to 1300°C for three hours, and then quenching it to ambient temperature, these segregations are dissolved to form a more homogeneous structure as can be seen from Fig. 5 which shows the same area of the crystal with the same magnification as Fig. 4 after such solutioning heat treatment. Also inner stresses and pores are removed. Most important, the gamma-prime precipitates are dissolved in preparation of subsequent heat treatments.

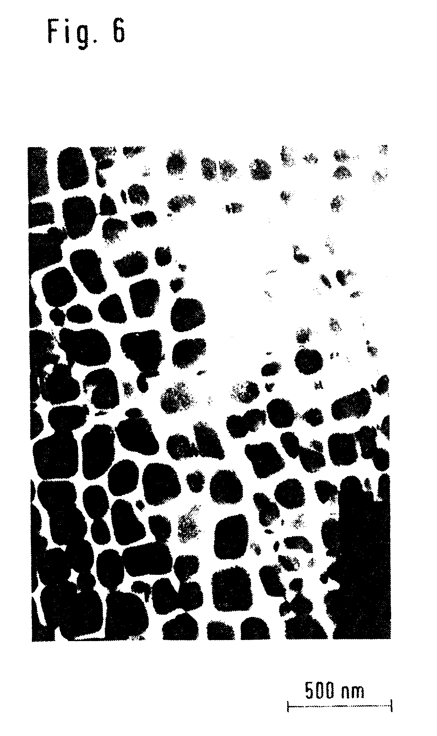

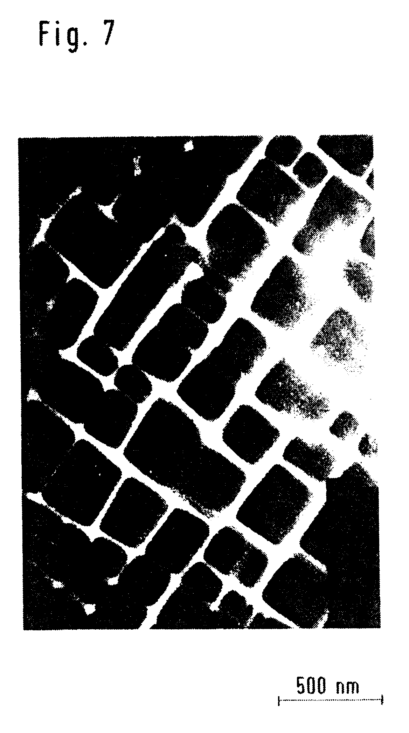

Subsequently, the workpiece is again heated up to 1100°C and kept there for four hours before quenching it to ambient temperature. As shown in Fig. 6, this treatment leads to finelly dispersed gamma-prime precipitates, however of an amount not yet optimum. An amount of gamma-prime of about 70 % may be achieved by subsequently heating the workpiece up to 850°C for 24 hours before it is quenched to ambient temperature again. This supplementary heat treatment brings to full effect the gamma-prime precipitation evenly distributed in the crystal as can be seen from Fig. 7. It should be noted that Fig. 6 and 7 constitute a magnification of about 50 000:1, i.e. magnify the representations of Fig. 4 and 5 by a factor of about 200. Here the gamma-prime precipitates within the gamma matrix are clearly to be seen. The precipitates have a size of about 400 nm in the average and thus render a very effective fine supporting structure against a migration of dislocations in the crystal that would result in creep effects.

Orifices 9 which are of small diameter, in case of fiberisation of basalt below 7/10 mm, may be manufactured with the aid of an YAG laser in percussion or cutting mode, or with electron beams. This treatment is in any event effected after the solutioning heat treatment, as is any machining, so as to minimize the risk of local parasite crystallisation. However, manufacture of orifices 9, and other machining operations, could be preferred before the recovery heat treatments for the gamma-prime phase are carried out so as to take benefit from the absence of the hardening gamma-prime phase, and so as to avoid any adverse effects on the workpiece having been finally heat treated.

Table 2 below shows a variety of characteristics of the spinner, or rather the spinner material, as compared to a poly-crystal alloy (here one known as SG30 in the industry and disclosed in FR-A-2 536 385) as conventionally used for spinners in the production of glass wool, and to a spinner made of an ODS alloy. The ODS alloy selected in comparison is known as MA 758; for further details thereof reference is had to the Periodical "Advanced Materials & Processes" 10/90, Vol. 138, No. 4 pages 43 thru 50.

As Table 2 shows, oxidation by gas presents a problem of the example according to the invention as the hot attenuating gases might lead to an oxidation at the surface radially outside the protruding ring 10. To avoid this, a coating may be applied to these - and possibly also other - surfaces. Such coating is conventional in the jet propulsion industry to protect the turbine blades from oxidation by the hot turbine gases and may be applied and deposited as conventional there. Therefore, no further details are given herein.

**Table 2**

| Properties | Temperature | Conventional (SG30) | ODS (MA 758) | Example of Invention |
|---|---|---|---|---|
| strain resulting | 1000°C | 30 | 120 | 180 |
| in creep rupture | 1050°C | 25 | 95 | 155 |
| after 1000 h | 1100°C | ≈0 | 80 | 130 |
| (MPa) | 1200°C | 0 | 60 | 100 |
| | 1300°C | 0 | 35 | 60 |
| ductility | 1050°C | 6,5 | 10 | 19 |
| (%) | 1200°C | - | 9 | 17 |
| modulus of | ambient | 200 | 200 | [001]130 |
| elasticity | 1000°C | 130 | 130 | [111]300 |
| (GPa) | | | | |
| Corrosion resistance | | | | |
| - against glass | 1100°C | OK | OK | OK |
| - against basalt | 1250°C | - | OK | OK |
| Oxidation by gas | 1250°C | - | OK | problem |
| Coating | - | NONE | NONE | preferred |

Ductility is very important as it avoids a build-up of stresses e.g. due to temperature differences in operation. As can be seen from Table 2, the example of the invention is by far superior as regards ductility at high temperatures also with respect to ODS alloys. This is considered a very marked advantage as the high ductility limits the maximum stress values in stress peaks within the material by a more even distribution of stresses, and thus avoids local stress peaks that might induce local failure.

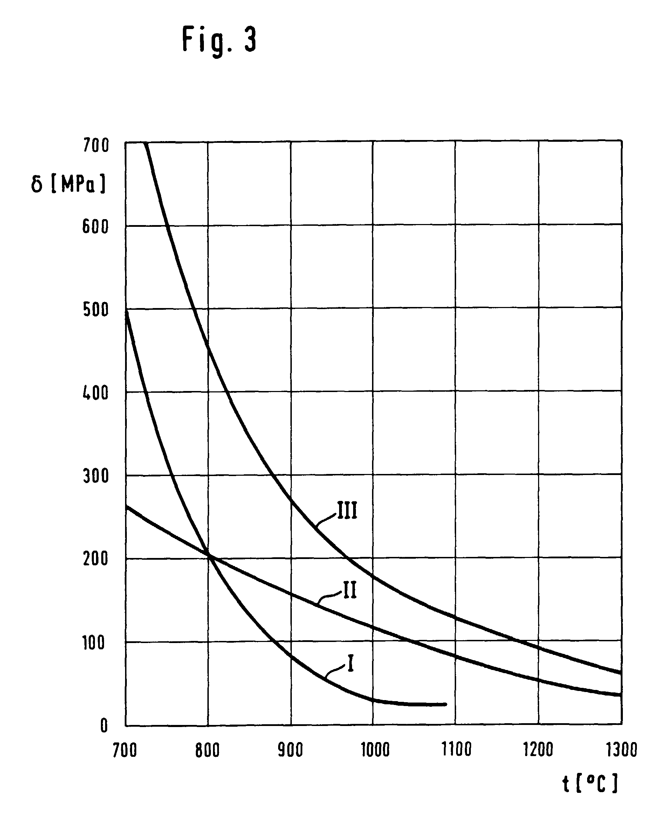

The strain resulting in creep rupture after 1000 h at high temperatures is the most important parameter to determine the useful service life time of a spinner. This parameter is exemplified also in Fig. 3 for a conventional alloy (curve I), a typical ODS alloy (curve II), and for the example of the invention represented by curve III in Fig. 3. As can be seen therefrom, the creep resistance of the spinner of the invention at moderately high temperatures of 1000°C and 1100°C is substantially superior to that of the ODS alloy, and at even lower temperatures the ODS alloy may be even less creep resistant than the conventional alloy. At temperatures above 1100°C, the alloy of the invention and the ODS alloy both have substantially decreased creep resistances, but the alloy of the invention can sustain still almost twice the strain of the ODS alloy before rupture after 1000 h (which is much more than a month of uninterrupted operation and thus quite a reasonable service life time for such a spinner).

The capability of sustaining higher strain at a high temperature before creep rupture after 1000 h on the one hand, and the high ductility leading to a more even stress distribution within the material and avoiding stress peaks on the other hand cooperate to make the spinner of the invention best suited for operation at high temperatures as they are preferred in the fiberization of rock wool like basalt by internal centrifugation. Also, the corrosion resistance even against the more agressive basalt material is satisfactory with the spinner of the invention. A potential higher probability of oxidation by gas may easily be prevented by a corresponding coating as conventionally used for turbine blades. The production of a spinner of the invention by a casting process reduces its production costs and allows use of the basic equipment and know-how accumulated in the industry of spinner production. This is not the case with ODS material which also shows satisfactory corrosion resistance, but must be produced by special production processes different from casting, i.e. by ring rolling.

## Claims

1. Metal spinner component for producing wool or other fibre products made of mineral material, such production including melting said material and bringing its melt into contact with said component, said component consisting of or at least comprising, where it is in contact with said melt, a unitary cast piece of a metal alloy, wherein said unitary cast piece is in the form of a single crystal.

2. The component of claim 1, wherein the growth direction of said single crystal is at least substantially parallel to an axis (3) of symmetry of said component (1).

3. The components of claim 1 or 2, wherein the growth direction of said single crystal coincides with the [001] orientation of said single crystal.

4. The component of any one of claims 1 to 3 being in the form of a spinner (1) for producing mineral wool material by centrifugation of molten mineral material, said spinner (1) comprising a radially outer peripheral wall (5) having a multitude of orifices (9) of small diameter for the penetration of molten mineral material to the outside of said wall (5), and capable of being rotated at high speed around a central axis (3) of symmetry of said spinner (1), wherein said metal alloy is a metal superalloy preferably on the basis of nickel or cobalt.

5. The component of any one of the preceding claims, wherein the single crystal alloy is a carbide hardened superalloy having the following components (in weight per cent):
Cr 20 - 35 %
Co 0 - 20 %
Mo traces at most
W 0 - 12 %
Ti traces at most
Ta 0 - 5 %
Re, Y, La and other rare earths < 2 %
C 0.1 - 3 %
Si 0 - 3 %
Mn 0 - 2 %
Fe 0 - 10 %
Ni remainder

6. The component of any one of the preceding claims, wherein the single crystal alloy is a carbide hardened superalloy having the following components (in weight per cent):
Cr 20 - 40 %
Ni 0 - 15 %
Mo traces at most
W 0 - 12 %
Ti traces at most
Ta 0 - 5 %
Re, Y, La and other rare earths < 2 %
C 0.1 - 1 %
Fe 0 - 10 %
Co remainder

7. The component of claim 5, wherein the single crystal superalloy has the following components (in weight per cent):
Cr 29 %
W 7.4 %
C 0.7 %
Si 1.2 %
Mn 0.9 %
Fe 7.5 %
Ni remainder

8. The component of any one of claims 1 to 4, wherein the single crystal alloy is a gamma-prime hardened superalloy having the following components (in weight per cent):
Cr 5 - 20 %, preferably up to 10 %
Co 4.5 - 15 %
Mo 0 - 20 %
W 0 - 10 %
Al 3 - 6 %
Ti 0 - 3.5 %
Ta 0 - 15 %
Re 0 - 3 %
V 0 - 1 %
Hf 0 - 1.4 %
C 0 - 0.07 %
Ni remainder

9. The component of claim 8, wherein the single crystal superalloy has the following components (in weight per cent):
Cr 6 - 10 %
Co 4.5 - 7 %
Mo 1 - 3 %
W 4 - 10 %
Al 5 - 6 %
Ti 1 - 3 %
Ta 2 - 10 %
Re 0 - 2 %
Ni remainder

10. The component of claim 9, wherein the single crystal superalloy has the following components (in weight per cent):
Cr 8 %
Co 5.5 %
Mo 2.25 %
W 5 %
Al 6 %
Ti 2 %
Ta 3.5 %
Ni remainder

11. The component of claim 9 wherein the single crystal superalloy has the following components (in weight per cent):
Cr 7.8 %
Co 6.5 %
Mo 2 %
W 5.7 %
Al 5.2 %
Ti 1.1 %
Ta 7.9 %
Ni remainder

12. The component of claim 9, wherein the single crystal superalloy has the following components (in weight per cent)
Cr 8 %
Co 5 %
Mo 2 %
W 8 %
Al 5 %
Ti 1.5 %
Ta 6 %
Ni remainder

13. The component of any one of the preceding claims wherein at least part of its surfaces is protected against corrosive and/or oxidizing attacks by a coating.

14. The component of claim 13 wherein said coating is provided at the outer surfaces exposed to the hot gases of an outer burner producing an attenuating gas stream.

15. A method for producing a component of any one of the preceding claims, wherein a melt of the superalloy material is introduced into a casting receptacle (11) comprising a lower crystal forming chamber (12) having a cooled surface (13) and an upper workpiece forming chamber (15) capable of being heated, with a single crystal selecting constriction (16) therebetween, and that the single crystal growing from the constriction (16) into the upper chamber (15) to take up the form of the workpiece is gradually solidified by changing the relative position between the casting receptacle (11) and the heating means (20) such that there is established a temperature gradient from the constriction (16) to the opposite end of the workpiece to be formed.

16. The method of claim 15 wherein said temperature gradient is below 70°C/cm, preferably below 50°C/cm, but in excess of 30°C/cm, preferably at 40°C/cm.

17. The method of claims 15 or 16, wherein said velocity of change of the relative position between the casting receptacle (11) and the heating means (20) has a maximum in the order of between 15 and 35 cm/h.

18. The method of any one of the preceding claims wherein the walls of said casting receptacle (11) are of ceramic material obtained from forming a ceramic material layer on the surface of a model made from material removable by heat like wax or organic plastic material, such model taking the form of said workpiece plus spaces to be filled by molten alloy material, with the model material being removed from the ceramic mould before casting of the molten alloy material.

19. The method of any one of the preceding claims wherein a subsequent heat treatment includes heating the workpiece to a temperature T₁ between the solution temperature T_{SOLVUS} for the eutectic mixture of the gamma matrix and particulate precipitation phases on the one hand and the temperature T_{SOLIDUS} of the alloy on the other hand for more than one hour, preferably three hours, so as to dissolve segregations and all of the particulate precipitation phase.

20. The method of claim 19, wherein said temperature T₁ is between 1150°C and 1350°C, and in case of the superalloy of claim 12 is 1300°C.

21. The method of claim 19 or 20 wherein, after having quenched the workpiece to ambient temperature, the heat treatment includes heating the workpiece up to a temperature T₂ at a level of between 150°C and 200°C below the solution temperature T_{SOLVUS} for the eutectic mixture of gamma and gamma-prime phases for a duration of more than one hour, preferably four hours and, after having again quenched the workpiece to ambient temperature, again heating it up to a temperature T₃ of between 400°C and 500°C below the solution temperature T_{SOLVUS} for the eutectic mixture of the gamma and gamma-prime phases for a duration of more than 10 hours, preferably 24 hours, so as to provoke a homogenous distribution of small size precipitates and a sufficient amount thereof.

22. The method of claim 21 wherein in case of the superalloy of claim 12 T₂ is 1100°C and T₃ is 850°C.

## Patentansprüche

1. Metallisches Schleuderorgan-Bauteil für die Herstellung von Wolle oder anderen Faserprodukten aus mineralischem Material unter Erschmelzen des Materials und Zusammenführen seiner Schmelze mit dem Bauteil, wobei das Bauteil dort, wo es mit der Schmelze in Berührung kommt, aus einem einstückig hergestellten Gußteil aus einer metallischen Legierung besteht oder zumindest ein solches aufweist, dadurch gekennzeichnet, daß das einstückig hergestellte Gußteil als Einkristall ausgebildet ist.

2. Bauteil nach Anspruch 1, dadurch gekennzeichnet, daß die Wachstumsrichtung des Einkristalls zumindest im wesentlichen parallel zu einer Symmetrieachse (3) des Bauteils (1) ist.

3. Bauteil nach Anspruch 1 oder 2, dadurch gekennzeichnet, daß die Wachstumsrichtung des Einkristalls mit der [001]-Orientierung des Einkristalls zusammenfällt.

4. Bauteil nach einem der Ansprüche 1 bis 3 in Form eines Schleuderorgans (1) für die Herstellung von Mineralwollematerial mittels Zentrifugieren einer mineralischen Schmelze, wobei das Schleuderorgan (1) eine in Radialrichtung außen befindliche Umfangswand (5) mit einer Vielzahl von Öffnungen (9) mit kleinem Durchmesser aufweist, durch welche die mineralische Schmelze zur Außenseite der Wand (5) hin durchtritt, und mit hoher Geschwindigkeit um eine zentrale Symmetrieachse (3) des Schleuderorgans (1) drehbar ist, dadurch gekennzeichnet, daß die Metallegierung eine metallische Superlegierung vorzugsweise auf der Basis von Nickel oder Kobalt ist.

5. Bauteil nach einem der vorhergehenden Ansprüche, dadurch gekennzeichnet, daß die Einkristall-Legierung eine carbidgehärtete Superlegierung mit den folgenden Bestandteilen (in Gew.-%) ist:
Cr 20 - 35 %
Co 0 - 20 %
Mo höchstens Spuren
W 0 - 12 %
Ti höchstens Spuren
Ta 0 - 5 %
Re, Y, La und weitere seltene Erden < 2 %
C 0,1 - 3 %
Si 0 - 3 %
Mn 0 - 2 %
Fe 0 - 10 %
Ni Rest

6. Bauteil nach einem der vorhergehenden Ansprüche, dadurch gekennzeichnet, daß die Einkristall-Legierung eine carbidgehärtete Superlegierung mit den folgenden Bestandteilen (in Gew.-%) ist:
Cr 20 - 40 %
Ni 0 - 15 %
Mo höchstens Spuren
W 0 - 12 %
Ti höchstens Spuren
Ta 0 - 5 %
Re, Y, La und weitere seltene Erden < 2 %
C 0,1 - 1 %
Fe 0 - 10 %
Co Rest

7. Bauteil nach Anspruch 5, dadurch gekennzeichnet, daß die Einkristall-Superlegierung die folgenden Bestandteile (in Gew.-%) aufweist:
Cr 29 %
W 7,4 %
C 0,7 %
Si 1,2 %
Mn 0,9 %
Fe 7,5 %
Ni Rest

8. Bauteil nach einem der Ansprüche 1 bis 4, dadurch gekennzeichnet, daß die Einkristall-Legierung eine γ'-gehärtete Superlegierung mit den folgenden Bestandteilen (in Gew.-%) ist:
Cr 5 - 20 %, bevorzugt bis zu 10 %
Co 4,5 - 15 %
Mo 0 - 20 %
W 0 - 10 %
Al 3 - 6 %
Ti 0 - 3,5 %
Ta 0 - 15 %
Re 0 - 3 %
V 0 - 1 %
Hf 0 - 1,4 %
C 0 - 0,07 %
Ni Rest

9. Bauteil nach Anspruch 8, dadurch gekennzeichnet, daß die Einkristall-Superlegierung die folgenden Bestandteile (in Gew.-%) aufweist:
Cr 6 - 10 %
Co 4,5 - 7 %
Mo 1 - 3 %
W 4 - 10 %
Al 5 - 6 %
Ti 1 - 3 %
Ta 2 - 10 %
Re 0 - 2 %
Ni Rest

10. Bauteil nach Anspruch 9, dadurch gekennzeichnet, daß die Einkristall-Superlegierung die folgenden Bestandteile (in Gew.-%) aufweist:
Cr 8 %
Co 5,5 %
Mo 2,25 %
W 5 %
Al 6 %
Ti 2 %
Ta 3,5 %
Ni Rest

11. Bauteil nach Anspruch 9, dadurch gekennzeichnet, daß die Einkristall-Superlegierung die folgenden Bestandteile (in Gew.-%) aufweist:
Cr 7,8 %
Co 6,5 %
Mo 2 %
W 5,7 %
Al 5,2 %
Ti 1,1 %
Ta 7,9 %
Ni Rest

12. Bauteil nach Anspruch 9, dadurch gekennzeichnet, daß die Einkristall-Superlegierung die folgenden Bestandteile (in Gew.-%) aufweist:
Cr 8 %
Co 5 %
Mo 2 %
W 8 %
Al 5 %
Ti 1,5 %
Ta 6 %
Ni Rest

13. Bauteil nach einem der vorhergehenden Ansprüche, dadurch gekennzeichnet, daß mindestens ein Teil seiner Oberflächen durch eine Beschichtung gegen korrodierende und/oder oxidierende Angriffe geschützt ist.

14. Bauteil nach Anspruch 13, dadurch gekennzeichnet, daß die Beschichtung an den Außenflächen vorgesehen ist, welche den heißen Gasen eines äußeren Brenners für die Erzeugung eines Ausziehgasstroms ausgesetzt sind.

15. Verfahren für die Herstellung eines Bauteils nach einem der vorhergehenden Ansprüche, dadurch gekennzeichnet, daß eine Schmelze des Superlegierungsmaterials in eine Gußform (11) eingebracht wird, welche eine untere Kristallbildungskammer (12) mit einer gekühlten Oberfläche (13) und eine beheizbare obere Werkstück-Bildungskammer (15) sowie eine zwischen diesen angeordnete Einkristall-Selektionseinschnürung (16) aufweist, und daß der Einkristall, welcher derart aus der Einschnürung (16) in die obere Kammer (15) wächst, daß er die Form des Werkstückes einnimmt, mittels Veränderung der relativen Lage von Gußform (11) und Heizeinrichtung (20) zueinander allmählich verfestigt wird, so daß von der Einschnürung (16) bis zu dem gegenüberliegenden Ende des zu bildenden Werkstückes ein Temperaturgradient hergestellt wird.

16. Verfahren nach Anspruch 15, dadurch gekennzeichnet, daß der Temperaturgradient weniger als 70°C/cm, bevorzugt weniger als 50°C/cm, jedoch mehr als 30°C/cm, bevorzugt 40°C/cm beträgt.

17. Verfahren nach Anspruch 15 oder 16, dadurch gekennzeichnet, daß die Geschwindigkeit der Veränderung der relativen Lage von Gußform (11) und Heizeinrichtung (20) zueinander ein Maximum in der Größenordnung von zwischen 15 und 35 cm/h aufweist.

18. Verfahren nach einem der vorhergehenden Ansprüche, dadurch gekennzeichnet, daß die Wandungen der Gußform (11) aus Keramikmaterial bestehen und dadurch hergestellt werden, daß auf der Oberfläche eines Modelles aus durch Wärme entfernbarem Material wie Wachs oder organischem Plastikmaterial eine Schicht eines Keramikmaterials ausgebildet wird, so daß ein derartiges Modell die Formgebung des Werkstückes einschließlich durch das Legierungs-Schmelzematerial zu füllender Zwischenräume aufweist, und das Modellmaterial vor dem Gießen des Legierungs-Schmelzematerials von der Keramikform entfernt wird.

19. Verfahren nach einem der vorhergehenden Ansprüche, dadurch gekennzeichnet, daß eine nachfolgende Wärmebehandlung aufweist: Erwärmen des Werkstückes auf eine Temperatur T₁ zwischen der Lösungstemperatur T_{SOLVUS} zum eutektischen Mischen der γ-Matrix und einzelner Ausscheidungsphasen einerseits und der Temperatur T_{SOLIDUS} der Legierung andererseits während einer Dauer von mehr als einer Stunde, bevorzugt drei Stunden, um Entmischungen und jegliche einzelne Ausscheidungsphase aufzulösen.

20. Verfahren nach Anspruch 19, dadurch gekennzeichnet, daß die Temperatur T₁ zwischen 1150°C und 1350°C liegt und im Fall der Superlegierung nach Anspruch 12 1300°C beträgt.

21. Verfahren nach Anspruch 19 oder 20, dadurch gekennzeichnet, daß nach dem Abschrecken des Werkstückes auf Umgebungstemperatur die Wärmebehandlung aufweist: Erwärmen des Werkstückes auf eine Temperatur T₂ auf einem Niveau zwischen 150°C und 200°C unterhalb der Lösungstemperatur T_{SOLVUS} zum eutektischen Mischen der γ-Phase und der γ'-Phase während einer Dauer von mehr als einer Stunde, bevorzugt vier Stunden, und nach erneutem Abschrecken des Werkstückes auf Umgebungstemperatur erneut Erwärmen auf eine Temperatur T₃ von zwischen 400°C und 500°C unterhalb der Lösungstemperatur T_{SOLVUS} zum eutektischen Mischen der γ-Phase und der γ'-Phase während einer Dauer von mehr als 10 Stunden, bevorzugt 24 Stunden, um eine gleichmäßige Verteilung von Ausscheidungen mit geringer Größe und eine ausreichende Menge davon hervorzurufen.

22. Verfahren nach Anspruch 21, dadurch gekennzeichnet, daß im Falle der Superlegierung nach Anspruch 12 T₂ 1100°C und T₃ 850°C betragen.

## Revendications

1. Composant métallique de dispositif de production d'une matière fibreuse, pour la production de laine ou d'autres produits fibreux faits de matières minérales, cette production comprenant la fusion de ladite matière, et la mise en contact de la matière fondue avec ledit composant, ledit composant consistant en, ou comprenant au moins, à l'endroit où il est en contact avec ladite matière en fusion, une pièce unitaire fondue, faite d'un alliage métallique, dans lequel ladite pièce unitaire fondue est sous la forme d'un monocristal.

2. Composant selon la revendication 1, dans lequel la direction de croissance dudit monocristal est au moins pratiquement, parallèle à un axe (3) de symétrie dudit composant (1).

3. Composant selon la revendication 1, ou la revendication 2, dans lequel la direction de croissance dudit monocristal coïncide avec l'orientation [001] dudit monocristal.

4. Composant selon l'une quelconque des revendications 1 à 3, qui est sous la forme d'un dispositif de production d'une matière fibreuse (1) pour la production d'une matière en laine minérale, par centrifugation d'une matière minérale fondue, ledit dispositif de production d'une matière fibreuse (1) comprenant une paroi périphérique radiale externe (5) comportant une multitude d'orifices (9) de petit diamètre, pour la pénétration de la matière minérale fondue vers l'extérieur de ladite paroi (5), et qui peut être mise en rotation à grande vitesse autour d'un axe central (3) de symétrie dudit dispositif de production d'une matière fibreuse (1), dans lequel ledit alliage métallique est un super-alliage métallique, de préférence, à base de nickel ou de cobalt.

5. Composant selon l'une quelconque des revendications précédentes, dans lequel l'alliage du monocristal est un super-alliage durci au carbure, et comprenant les composants suivants (en pourcentages pondéraux) :
Cr 20 - 35 %
Co 0-20 %
Mo au plus, des traces
W 0-12 %
Ti au plus, des traces
Ta 0-5 %
Re, Y, La et autres terres rares < 2 %
C 0,1-3 %
Si 0-3 %
Mn 0-2 %
Fe 0-10 %
Ni le reste.

6. Composant selon l'une quelconque des revendications précédentes, dans lequel l'alliage du composant monocristallin est un super-alliage durci au carbure et comprenant les composants suivants (en pourcentages pondéraux) :
Cr 20 - 40 %
Ni 0-15 %
Mo au plus, des traces
W 0-12 %
Ti au plus, des traces
Ta 0-5 %
Re, Y, La et autres terres rares < 2 %
C 0,1-1 %
Fe 0-10 %
Co le reste.

7. Composant selon la revendication 5, dans lequel le super-alliage du monocristal comprend les composants suivants (en pourcentages pondéraux) :
Cr 29 %
W 7,4 %
C 0,7 %
Si 1,2 %
Mn 0,9 %
Fe 7,5 %
Ni le reste.

8. Composant selon l'une quelconque des revendications 1 à 4, dans lequel l'alliage du monocristal est un super-alliage durci gamma-prime, et comprenant les composants suivants (en pourcentages pondéraux) :
Cr 20 - 40 %, de préférence, jusqu'à 10 %
Co 4,5- 15 %
Mo 0 -20 %
W 0-10 %
Al 3-6 %
Ti 0-3,5 %
Ta 0-15 %
Re 0-3 %
V 0-1 %
Hf 0-1,4 %
C 0-0,07 %
Ni le reste

9. Composant selon la revendication 8, dans lequel le super-alliage du monocristal comprend les composants suivants (en pourcentage pondéraux) :
Cr 6-10 %
Co 4,5 - 7 %
Mo 1 -3 %
W 4-10 %
Al 5-6 %
Ti 1-3 %
Ta 2-10 %
Re 0-2 %
Ni le reste

10. Composant selon la revendication 9, dans lequel le super-alliage du monocristal comprend les composants suivants (en pourcentage pondéraux) :
Cr 8 %
Co 5,5 %
Mo 2,25 %
W 5 %
Al 6 %
Ti 2 %
Ta 3,5 %
Ni le reste

11. Composant selon la revendication 9, dans lequel le super-alliage du monocristal comprend les composants suivants (en pourcentage pondéraux) :
Cr 7,8 %
Co 6,5 %
Mo 2 %
W 5,7 %
Al 5,2 %
Ti 1,1 %
Ta 7,9 %
Ni le reste

12. Composant selon la revendication 9, dans lequel le super-alliage du monocristal comprend les composants suivants (en pourcentage pondéraux) :
Cr 8 %
Co 5 %
Mo 2%
W 8 %
Al 5 %
Ti 1,5 %
Ta 6 %
Ni le reste

13. Composant selon l'une quelconque des revendications précédentes, dans lequel une partie au moins de ses surfaces est protégée par un revêtement contre les attaques corrosives et/ou oxydantes.

14. Composant selon la revendication 13, dans lequel ledit revêtement est disposé sur les surfaces extérieures exposées aux gaz chauds d'un brûleur extérieur produisant un courant gazeux d'atténuation.

15. Méthode de production d'un composant selon l'une quelconque des revendications précédentes, dans laquelle de la matière fondue faite de super-alliage, est introduite dans un réceptacle de coulée (11) comprenant une chambre inférieure de formation de cristaux (12), ayant une surface refroidie (13), et une chambre supérieure de formation de pièce (15), pouvant être chauffée, avec entre elles, une constriction sélectionnant le monocristal, et dans laquelle le monocristal croissant depuis la constriction (16) jusque dans la chambre supérieure (15) pour prendre la forme de la pièce, est progressivement solidifié par changement de position relative entre le réceptacle de coulée (11) et les moyens de chauffage (20), de sorte qu'il s'établit un gradient de température depuis la constriction (16) vers l'extrémité opposée de la pièce à former.

16. Méthode selon la revendication 15, dans laquelle ledit gradient de température est inférieur à 70°C/cm, de préférence, inférieur à 50°C/cm, mais supérieur à 30°C/cm, de préférence, égal à 40°C/cm.

17. Méthode selon la revendication 15 ou la revendication 16, dans laquelle ladite vitesse de changement de la position relative entre le réceptacle de coulée (11), et les moyens de chauffage (20) a un maximum qui est de l'ordre de 15 à 35 cm/heure.

18. Méthode selon l'une quelconque des revendications précédentes, dans laquelle les parois dudit réceptacle de coulée (11) sont en matériau céramique obtenu par formation d'une couche de matériau céramique sur la surface d'un modèle fait de matériau pouvant être éliminé par la chaleur, tel que la cire ou un matériau plastique organique, un tel modèle prenant la forme de ladite pièce, plus des espaces à remplir par le matériau fait d'alliage fondu, et le matériau du modèle étant éliminé du moule céramique avant la coulée du matériau fait d'alliage fondu.

19. Méthode selon l'une quelconque des revendications précédentes, dans laquelle un traitement ultérieur à la chaleur comprend le chauffage de la pièce à une température T₁ comprise entre la température de la solution, T_{SOLVUS}, pour le mélange eutectique de la matrice gamma, et des phases de précipitation particulaire, d'une part, et la température T_{SOLIDUS} de l'alliage, d'autre part, pendant plus d'une heure, de préférence, pendant trois heures, de façon à dissoudre les ségrégations, et toutes les phases de précipitation particulaire.

20. Méthode selon la revendication 19, dans laquelle ladite température T₁ est comprise entre 1.150°C et 1.350°C, et dans le cas du super-alliage selon la revendication 12, est de 1.300°C.

21. Méthode selon la revendication 19, ou la revendication 20, dans laquelle après avoir trempé la pièce à température ambiante, le traitement thermique comprend le chauffage de la pièce jusqu'à une température T₂, à un niveau se situant entre 150°C et 200°C, au dessous de la température de la solution, T_{SOLVUS} pour le mélange eutectique des phases gamma et gamma-prime, pendant une durée de plus d'une heure, de préférence, deux heures, et dans laquelle, après avoir trempé de nouveau la pièce à température ambiante, on la chauffe de nouveau jusqu'à une température T₃ comprise entre 400°C et 500°C, au dessous de la température T_{SOLVUS} pour le mélange eutectique des phases gamma et gamma-prime, pendant une durée de plus de 10 heures, de préférence, 24 heures, de façon à provoquer une distribution homogène des précipités de petite taille, et une quantité suffisante de ceux-ci.

22. Méthode selon la revendication 21, dans laquelle, dans le cas du super-alliage selon la revendication 12, T₂ est égal à 1.100°C, et T₃ est égal à 850°C.
